# EUROPEAN PATENT APPLICATION

(11) **EP 4 589 651 A1**
(43) Date of publication of application: **23.07.2025**
(21) Application number: 25151708.2
(22) Date of filing: 14.01.2025
(51) Int. Cl.: H01L 23/053, H01L 23/552, H01L 23/04

(54) **POWER MODULE AND POWER CONVERTER**

(30) Priority: 16.01.2024 CN 202420106344 U
(71) Applicant: Huawei Digital Power Technologies Co., Ltd., Shenzhen, Guangdong 518043 (CN)
(72) Inventor: ZHANG, Shibo, Shenzhen, 518043 (CN)
(74) Representative: Epping - Hermann - Fischer

(57) **Abstract**

This application provides a power module and a power converter. The power module includes a thermally conductive member, a chip, a plurality of pins, and a shielding member. The shielding member is disposed on a side that is of the thermally conductive member and that is close to the chip, accommodating space is formed between the shielding member and the thermally conductive member, the chip and the substrate are located in the accommodating space, and the other end of each of the plurality of pins is exposed relative to the shielding member. In this application, the thermally conductive member is disposed, so that the power module has a relatively good heat dissipation capability. The shielding member is disposed, and the shielding member and the thermally conductive member are fastened, so that components such as the chip and the substrate can be better fastened and accommodated, electromagnetic shielding can be performed on the chip and/or the substrate as a whole, and shielding effect of the power module is improved. In this way, the power module can shield electromagnetic interference from the outside and shield electromagnetic interference from the inside of the power module to the outside, so that the power module has relatively stable and reliable operating performance, and has relatively small impact on another external electronic component.

## Description

### TECHNICAL FIELD

This application relates to the field of semiconductor technologies, and in particular, to a power module and a power converter.

### BACKGROUND

A power module (Power module) is an electronic device for managing and regulating power transmission and conversion. Electromagnetic interference of a power module refers to impact of electromagnetic radiation or an interference signal generated by the power module during operation on a surrounding electronic device, a communication system, or another sensitive circuit. Such interference may cause interference between devices, a communication error, performance deterioration, or a system fault. Therefore, the power module needs to be electromagnetic shielded (Electromagnetically shielded).

### SUMMARY

An objective of embodiments of this application is to provide a power module and a power converter. The power module in this application has a relatively good electromagnetic shielding capability, and can effectively shield electromagnetic interference from the outside and shield electromagnetic interference from the inside of the power module to the outside, so that the power module has relatively stable and reliable operating performance, and has relatively small impact on another external electronic component.

According to a first aspect, this application provides a power module, including: a thermally conductive member; a substrate, disposed on the thermally conductive member; a chip, disposed on a side that is of the substrate and that faces away from the thermally conductive member; a plurality of pins, where one end of each of the plurality of pins is fastened on the side that is of the substrate and that faces away from the thermally conductive member, and the plurality of pins are electrically connected to the chip; and a shielding member, where the shielding member is disposed on a side that is of the thermally conductive member and that is close to the chip, accommodating space is formed between the shielding member and the thermally conductive member, the chip and the substrate are located in the accommodating space, and the other end of each of the plurality of pins is exposed relative to the shielding member. In this embodiment, the shielding member has a shielding capability, and the shielding member can conduct electricity, so that an equipotential body can be formed. The equipotential body can keep a surface of the power module at a same electric potential, thereby implementing effect of electromagnetic shielding between the outside and the inside of the power module. When an external electromagnetic wave is incident on a surface of the equipotential body, free electrons on the surface of the equipotential body with a same electric potential are redistributed, to generate an electric field with a same size as but in an opposite direction to the incident wave. Such a reverse electric field offsets an electric field of the incident wave, thereby reducing or preventing penetration of the electromagnetic wave and forming electromagnetic shielding. In addition, based on a similar principle, an electromagnetic wave inside the power module can also be shielded by the equipotential body to form electromagnetic shielding. Therefore, the shielding member can shield electromagnetic interference from both the inside and the outside of the power module.

Therefore, in this application, the thermally conductive member is disposed, so that the power module has a relatively good heat dissipation capability. The shielding member is disposed, and the shielding member and the thermally conductive member are fastened, so that components such as the chip and the substrate can be better fastened and accommodated, electromagnetic shielding can be performed on the chip and/or the substrate as a whole, and shielding effect of the power module is improved. In this way, the power module can shield electromagnetic interference from the outside and shield electromagnetic interference from the inside of the power module to the outside, so that the power module has relatively stable and reliable operating performance, and has relatively small impact on another external electronic component.

In some implementations, the shielding member has a top portion and a side portion, the side portion is disposed around the top portion, the side portion surrounds the chip and the substrate, and the shielding member is an integrally formed mechanical part.

In this implementation, the top portion and the side portion of the shielding member jointly form a semi-open cover structure of the shielding member, so that the shielding member has a relatively large accommodating volume and a relatively large shielding area. The integrally formed shielding member has good integrity, and easily forms an equipotential body, providing relatively good electromagnetic shielding effect.

In some implementations, the top portion is provided with a plurality of avoidance holes, and the plurality of pins penetrate the plurality of avoidance holes; and the avoidance holes and the pins are provided in a one-to-one correspondence, or one avoidance hole is penetrated by a plurality of pins.

For example, the avoidance holes and the pins are disposed in a one-to-one correspondence, to be specific, a quantity of avoidance holes is the same as a quantity of pins, and opening positions of the avoidance holes are corresponding to the pins. This reduces removal of a material of the shielding member, and ensures shielding performance of the shielding member.

Alternatively, in some examples, the quantity of avoidance holes may be less than the quantity of pins, so that a plurality of pins may pass through one avoidance hole together. This reduces a quantity of times of opening of the avoidance holes, making preparation of the shielding member simpler.

In this implementation, the avoidance holes are provided on the top portion of the shielding member, so that the pins can be disposed in a form perpendicular to or approximately perpendicular to the substrate, and the pins can directly penetrate from the avoidance holes. This facilitates installation of the shielding member.

In some implementations, the shielding member includes a shield layer and an insulation layer, the shield layer and the insulation layer are fastened, the shield layer covers the accommodating space, the insulation layer is at least partially located on an outer side of the shield layer, the shield layer is made of a conductive material, and the insulation layer is made of an insulation material.

In this implementation, a structure of the shielding member is provided, so that the shielding member has relatively good insulation performance and shielding performance.

In some implementations, the shield layer is of a cover-shaped plate structure, and the shield layer is made of a composite material of tungsten and aluminum oxide.

In this implementation, the shield layer has relatively high strength and relatively good conductivity, so that structural strength of the shielding member is higher and shielding performance is better.

In some implementations, the shielding member is provided with a plurality of avoidance holes, the plurality of pins penetrate the plurality of avoidance holes, and the insulation layer covers hole walls of the avoidance holes.

In this implementation, the shield layer forms an insulation structure at the avoidance hole, to prevent the pin from being in electrical contact with the shield layer due to an installation error or an external force, and therefore prevent the pin from failing and improve reliability of the power module.

In some implementations, at least a partial structure of the thermally conductive member is a conductive structure, and the shielding member is connected to the conductive structure of the thermally conductive member.

In this implementation, the conductive structure of the thermally conductive member can also have an electromagnetic shielding function. The conductive structure of the thermally conductive member and the shielding member may further form an equipotential body, to form a closed or approximately closed box-shaped structure. The equipotential body can wrap a complete or major structure of the substrate and the chip, so that shielding effect of the power module is better.

In some implementations, the power module further includes a heat dissipation member, and the heat dissipation member is disposed on a side that is of the thermally conductive member and that faces away from the substrate; and the heat dissipation member is an air-cooled heat sink or a liquid cooling heat sink.

In this implementation, a structure of the heat dissipation member is disposed, so that a surface area of the heat dissipation member is larger and a heat dissipation capability is better, which improves heat dissipation efficiency of the power module.

In some implementations, the heat dissipation member is made of a metal material, and the heat dissipation member is connected to the shielding member.

In this implementation, the heat dissipation member may form a structure having a shielding capability as a whole, and the heat dissipation member and the shielding member may form a closed or approximately closed box-shaped structure, so that complete or major structures of the substrate and the chip can be wrapped, so that the shielding effect of the power module is better.

In some implementations, the power module further includes a packaging member, and the packaging member wraps the chip and at least a partial structure of the substrate and partial structures of the pins.

In this implementation, the packaging member can isolate the chip and the substrate from the outside, to avoid contact between the chip and the substrate and an external substance, and reduce impact of an external force. The packaging member can fasten and support the pins. Therefore, the packaging member can package the chip, the substrate, and the pins, and has a good protection capability.

In some implementations, the packaging member is located in the accommodating space, and a gap is reserved between the packaging member and the shielding member.

In this implementation, a gap is reserved between the packaging member and the shielding member, so that the shielding member as a whole is disposed on an outer side of the packaging member. This facilitates installation of the shielding member.

In some implementations, the packaging member includes a package body and protrusions, the package body wraps the chip and the substrate, and wraps a partial structure of the pin, the protrusion is disposed on a side that is of the package body and that faces away from the thermally conductive member, the protrusion is disposed around the pin, and a partial structure of the protrusion is embedded in the avoidance hole of the shielding member.

In this implementation, because the pin is relatively long, the protruding protrusion can cover more parts of the pin; and when the pin is subject to an external force, the pin may be prevented from direct contact with the hole wall of the avoidance hole. This improves reliability of the pin and improves reliability of the power module.

In some implementations, the packaging member wraps at least a structure of the shielding member that forms the accommodating space.

For example, the packaging member may wrap the top portion of the shielding member, the packaging member may further wrap side plates of the side portion of the shielding member, and fixed plates of the side portion may be exposed from the packaging member, which is equivalent to wrapping a major structure of the shielding member inside the packaging member.

In this implementation, the wrapped part in the packaging member does not have electrical contact with another external component, and does not have electrical contact with a pin. In addition, with the package by the packaging member, the shielding member is not directly impacted by an external force, the packaging member can protect the shielding member, and integrity of the power module is good.

In some implementations, the shielding member is provided with a flow-guiding hole, and a part that is of the packaging member and that is located on an outer side of the shielding member is connected to a part that is of the packaging member and that is located on an inner side of the shielding member through the flow-guiding hole.

In this implementation, the flow-guiding hole is provided, so that during forming of the packaging member, plastic packaging materials can be evenly distributed on an inner side and an outer side of the packaging member, to form an integrated packaging member.

In some implementations, the packaging member includes a connecting portion, the connecting portion is disposed around the pin, and the connecting portion is located in the avoidance hole of the shielding member.

In this implementation, the connecting portion is located in the avoidance hole of the shielding member, and may be in contact with the avoidance hole, so that the pin almost does not have an electrical contact with the shielding member, and reliability and stability of the pin are high.

According to a second aspect, an embodiment of this application provides a power converter, including a drive board and the power module provided in any one of the foregoing embodiments, where the power module is connected to the drive board.

In this embodiment, the power converter in this application has relatively stable and reliable operating performance.

### BRIEF DESCRIPTION OF DRAWINGS

To describe technical solutions in embodiments of this application or in the background more clearly, the following describes accompanying drawings in embodiments of this application or in the background.
FIG. 1 is a diagram of a structure of a power converter according to some embodiments of this application;
FIG. 2 is a diagram of a structure of the power module shown in FIG. 1 in some embodiments;
FIG. 3 is a diagram of an internal structure of the power module shown in FIG. 2 in some embodiments;
FIG. 4 is a diagram of a structure of the shielding member shown in FIG. 3 in some embodiments;
FIG. 5 is a sectional view of the shielding member shown in FIG. 3 in some embodiments;
FIG. 6 is an enlarged view of an A part of the shielding member shown in FIG. 5 in some other embodiments;
FIG. 7 is a partial view of the power module shown in FIG. 3 in some other embodiments;
FIG. 8 is a brief flowchart of a preparation method of the power module shown in FIG. 3 in some embodiments;
FIG. 9 is a diagram of an internal structure of the power module shown in FIG. 2 in some other embodiments;
FIG. 10 is a diagram of a structure of the shielding member shown in FIG. 9 in some embodiments; and
FIG. 11 is a brief flowchart of a preparation method of the power module shown in FIG. 9 in some embodiments.

### DESCRIPTION OF EMBODIMENTS

The following describes embodiments of this application with reference to the accompanying drawings in embodiments of this application.

In the descriptions of embodiments of this application, it should be noted that terms "installation" and "connection" should be understood in a broad sense unless there is a clear stipulation and limitation. For example, "connection" may be a detachable connection, a nondetachable connection, a direct connection, or an indirect connection through an intermediate medium. "Plurality" means at least two.

Orientation terms mentioned in embodiments of this application, for example, "upper", "lower", "inner", "outer", "top", "bottom", and "side" are merely directions based on the accompanying drawings. Therefore, the orientation terms are used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application.

In embodiments of this application, a limitation on a relative position relationship is mentioned, for example, parallel, perpendicular, or aligned. These limitations are all for a current process level, but are not absolute strict limitations. A small deviation is allowed, and may be approximately parallel, approximately perpendicular, approximately aligned, or the like. For example, that A is parallel to B means that A is parallel or approximately parallel to B, and an included angle of 0 degrees to 10 degrees between A and B is allowed. For example, that A is perpendicular to B means that A is perpendicular or approximately perpendicular to B, and an included angle of 80 degrees to 100 degrees between A and B is allowed.

In embodiments of this application, terms "first", "second", "third", and "fourth" are merely intended for a purpose of description, and shall not be understood as an indication or implication of relative importance or an implicit indication of a quantity of indicated technical features. Therefore, a feature defined by "first", "second", "third", or "fourth" may explicitly or implicitly include one or more of the features.

In embodiments of this application, the "integrally formed mechanical part" mentioned should be understood as that the mechanical part is an integral and inseparable, and also means that the mechanical part is not formed by assembling a plurality of parts. "Integrally formed" is not a strict limitation on a process, but may include an integrated molding process such as injection molding, blow molding, extrusion, stamping, or punching.

In some embodiments, this application provides a power module and a power converter including the power module. The power converter includes but is not limited to a power converter having a power module, such as a direct current-to-alternating current power converter or a direct current-to-direct current power converter, which is not strictly limited in this embodiment.

In some examples, the power converter may be applied to an electrical device. The electrical device includes but is not limited to a wind turbine, a photovoltaic generator, an electric vehicle, an industrial robot, an energy storage device, a server power supply, a personal charging device, and another electrical device having a power converter. In this embodiment, an example in which the electrical device is an electric vehicle is used for description.

For example, the electrical device may include a power converter and a housing, and the power converter is accommodated inside the housing. The electrical device has stable and reliable operating performance.

For example, when the electrical device is an electric vehicle, the power converter may be located inside the electric vehicle, and the power converter may be electrically connected to a motor and a battery, to convert power between the motor and the battery. The power converter may be used as a core apparatus for performing conversion between a direct current and an alternating current in a motor control unit of the electric vehicle, to output a direct current to the battery of the electric vehicle, or convert a direct current into an alternating current for running the electric vehicle, and so on.

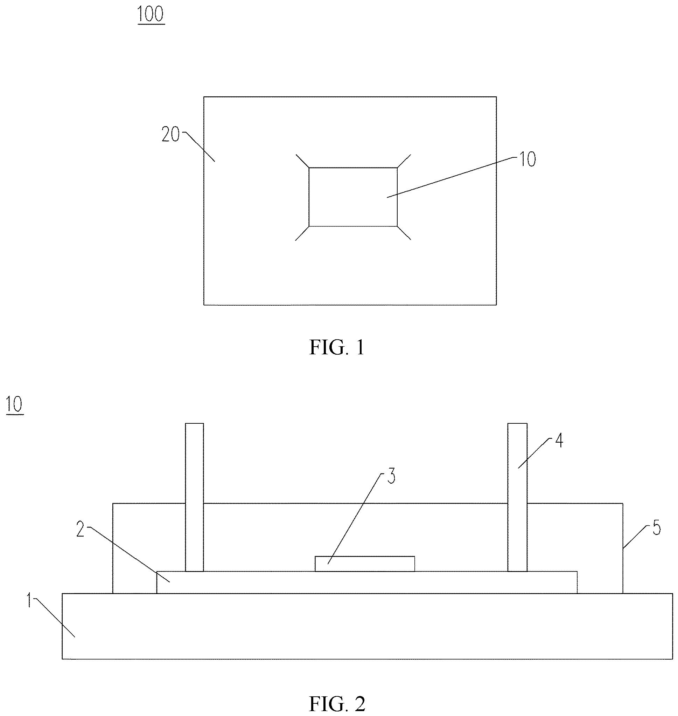

FIG. 1 is a diagram of a structure of a power converter 100 according to some embodiments of this application.

In some embodiments, the power converter 100 may include a power module 10 and a drive board 20. The power module 10 is installed on the drive board 20, and the drive board 20 is electrically connected to the power module 10 to control the power module 10. The power converter 100 using the power module 10 in this application has relatively stable and reliable operating performance.

The power module 10 is a semiconductor apparatus that can convert a voltage, a current, a cycle, and the like of a direct current output by a power supply.

For example, the power module 10 may convert a voltage of the power supply from one level to another level. For example, the power module 10 may convert a magnitude of the voltage.

For example, the power module 10 may control a magnitude of a current, to ensure that the current of the power supply is within an acceptable range, so as to prevent a device or a circuit from being damaged by an overcurrent.

For example, the power module 10 may have an inverse conversion function, and can convert a direct current power supply into an alternating current power supply, or convert an alternating current power supply into a direct current power supply. For example, the power module 10 may convert a direct current generated by a solar cell into an alternating current power supply that can be used for a home appliance.

For example, the power module 10 may have a temperature management function, to ensure that the power module 10 is not overheated during operation.

The drive board 20 may be electrically connected to the power module 10. For example, in an electric vehicle, the drive board 20 may control, according to a requirement of the electric vehicle, a performance parameter of an alternating current output by the power module 10 to the motor, for example, a voltage, a current, a cycle, or a frequency. This is not strictly limited in this embodiment.

FIG. 2 is a diagram of a structure of the power module 10 shown in FIG. 1 in some embodiments.

In some embodiments, the power module 10 may include a thermally conductive member 1, a substrate 2, a chip 3, a plurality of pins 4, and a shielding member 5.

The thermally conductive member 1 may be made of a material with good heat conductivity, for example, metal or metal alloy. A part of the thermally conductive member 1 exposed from the power module 10 may have a relatively large surface area, to increase a contact area with the outside of the power module 10 and improve heat dissipation effect of the thermally conductive member 1.

The substrate 2 may be disposed on the thermally conductive member 1. For example, the substrate 2 may be fastened to the middle of the thermally conductive member 1 through welding, so that a connection between the substrate 2 and the thermally conductive member 1 is more reliable, effect of transferring heat between the substrate 2 and the thermally conductive member 1 is better, and heat dissipation efficiency is higher. An area of the substrate 2 may be less than an area of the thermally conductive member 1, so that the thermally conductive member 1 can better support the substrate 2.

The chip 3 may be disposed on a side that is of the substrate 2 and that faces away from the thermally conductive member 1. The chip 3 may be one or more of an insulated gate bipolar transistor (IGBT), a metal-oxide-semiconductor field-effect transistor (MOSFET), or a fast recovery diode (FRD).

For example, the chip 3 may be fastened, through welding, on the side that is of the substrate 2 and that faces away from the thermally conductive member 1, and may be located in the middle of the substrate 2. There may be one or more chips 3. A top surface or a bottom surface of the chip 3 may be electrically connected to the substrate 2. A quantity, positions, and a connection manner of the chips 3 are not strictly limited in this embodiment.

The plurality of pins 4 may all be fastened on the side that is of the substrate 2 and that faces away from the thermally conductive member 1. For example, the plurality of pins 4 may be disposed around the chip 3, the plurality of pins 4 may be electrically connected to the chip 3, and the pins 4 are configured to be electrically connected to another external component, so that the chip 3 can operate.

The shielding member 5 may be disposed on a side that is of the thermally conductive member 1 and that is close to the chip 30. At least a partial structure of the shielding member 5 has a shielding capability. Accommodating space may be formed between the shielding member 5 and the thermally conductive member 1. The chip 3 and the substrate 2 are located in the accommodating space. In this case, one end of the pin 4 is fastened to the substrate 2, and the other end of the pin 4 may be exposed relative to the shielding member 5, so that the pin 4 can be electrically connected to an external component.

For example, the shielding member 5 may be fastened to the thermally conductive member 1 by using a fastener such as a screw, or the shielding member 5 may be fastened to the thermally conductive member 1 through welding. This is not strictly limited in this embodiment.

In addition, the shielding member 5 may be roughly of a cover structure. The shielding member 5 may be disposed on the thermally conductive member 1, the shielding member 5 and the thermally conductive member 1 form the accommodating space, and the chip 3 and the substrate 2 are located in the accommodating space, so that the chip 3 and the substrate 2 can be well protected and borne.

For example, a complete or partial structure of the shielding member 5 forms a shielding structure having a shielding capability. Electromagnetic shielding may be performed on the chip 3 or the substrate 2 in a region covered by the shielding structure. It may be understood that the shielding structure may be made of a conductive material such as metal, and the shielding structure of the shielding member 5 may be a plate structure, a film coating structure, or a mesh structure, which is not strictly limited in this embodiment.

The power module 10 tends to generate electromagnetic interference during operation. Electromagnetic radiation or an interference signal generated by the power module 10 easily affects a surrounding electronic device, a communication system, or another sensitive circuit. Such electromagnetic interference may cause interference between devices, a communication error, performance deterioration, or a system fault.

In this embodiment, the shielding structure is a conductive structure having an electromagnetic shielding capability. The shielding structure can conduct electricity, so that an equipotential body can be formed. The equipotential body can keep a surface of the power module 10 at a same electric potential, thereby implementing effect of electromagnetic shielding between the outside and the inside of the power module 10. When an external electromagnetic wave is incident on a surface of the equipotential body, free electrons on the surface of the equipotential body with a same electric potential are redistributed, to generate an electric field with a same size as but in an opposite direction to the incident wave. Such a reverse electric field offsets an electric field of the incident wave, thereby reducing or preventing penetration of the electromagnetic wave and forming electromagnetic shielding. In addition, based on a similar principle, an electromagnetic wave inside the power module 10 can also be shielded by the equipotential body to form electromagnetic shielding. Therefore, the shielding member 5 can shield electromagnetic interference from both the inside and the outside of the power module 10.

Therefore, in this application, the thermally conductive member 1 is disposed, so that the power module 10 has a relatively good heat dissipation capability. The shielding member 5 is disposed, and the shielding member 5 and the thermally conductive member 1 are fastened, so that components such as the chip 3 and the substrate 2 can be better fastened and accommodated, electromagnetic shielding can be performed on the chip 3 and/or the substrate 2 as a whole, and shielding effect of the power module 10 is improved. In this way, the power module 10 can shield electromagnetic interference from the outside and shield electromagnetic interference from the inside of the power module 10 to the outside, so that the power module 10 has relatively stable and reliable operating performance, and has relatively small impact on another external electronic component.

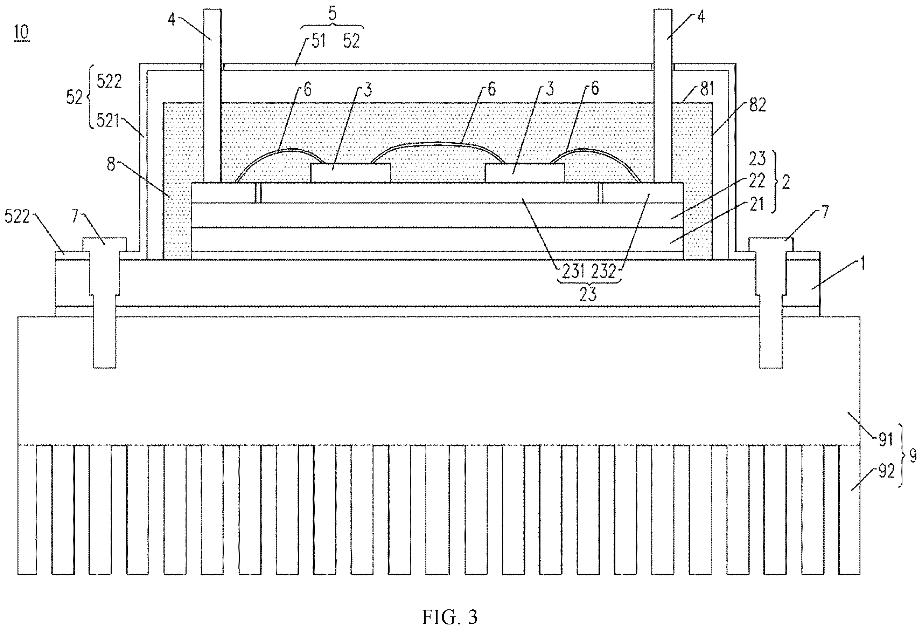

FIG. 3 is a diagram of an internal structure of the power module 10 shown in FIG. 2 in some embodiments.

In some embodiments, the substrate 2 may include a metal substrate 21, an insulation substrate 22, and a conductive layer 23.

For example, the metal substrate 21, the insulation substrate 22, and the conductive layer 23 may be fastened together sequentially, and the metal substrate 21 and the conductive layer 23 are respectively located on two opposite surfaces of the insulation substrate 22. The conductive layer 23 may be configured to construct a conductive circuit.

The chip 3 may be fastened to the conductive layer 23. A bottom surface of the chip 3 may be welded to the conductive layer 23. The power module 10 may include a bonding wire 6, and a top surface of the chip 3 may be electrically connected to the conductive layer 23 by using the bonding wire 6.

For example, the conductive layer 23 may include a first partition 231 and a second partition 232 that are independent of each other. The first partition 231 and the second partition 232 are independent of each other, and there is a gap between the first partition 231 and the second partition 232. The bottom of the chip 3 may be fastened to the first partition 231 of the conductive layer 23, and the top surface of the chip 3 may be electrically connected to the second partition 232 of the conductive layer 23 by using the bonding wire 6. In this case, the bonding wire 6 may belong to the power module 10. In some other implementations, the bottom of the chip 3 may be electrically connected to the first partition 231 of the conductive layer 23, and the top surface of the chip 3 may be electrically connected to the second partition 232 of the conductive layer 23 by using the bonding wire 6.

For example, the chip 3 may be fastened to the first partition 231 in a connection manner such as welding or bonding. For example, when the chip 3 needs to be electrically connected to the first partition 231, the chip 3 may be fastened to the first partition 231 through welding. When the chip 3 does not need to be electrically connected to the first partition 231, the chip 3 may be fastened to the first partition 231 in another manner such as bonding. A specific structure of the conductive layer 23 and a specific connection structure between the conductive layer 23 and the chip 3 are not strictly limited in this embodiment.

For example, there may be a plurality of chips 3. For example, there are two chips 3, and the two chips 3 may be electrically connected by using a bonding wire 6. In some other embodiments, there may be one chip 3. A quantity of chips 3 is not strictly limited in this embodiment.

The metal substrate 21 may be fastened to the thermally conductive member 1. For example, a surface that is of the metal substrate 21 and that faces away from the insulation substrate 22 may be welded to the thermally conductive member 1. In this case, by disposing the metal substrate 21, heat of the chip 3 can be effectively transferred to the thermally conductive member 1. This improves heat dissipation efficiency of the power module 10 for the chip 3. In addition, the metal substrate 21 can further effectively enhance strength of the substrate 2.

For example, the insulation substrate 22 may be made of an insulating and heat dissipation material such as ceramic.

For example, the insulation substrate 22 may be made of a ceramic material such as aluminum oxide, silicon nitride, or aluminum nitride. The ceramic material has a good insulation capability and good heat dissipation effect, to dissipate heat for the chip 3. A material of the insulation substrate 22 is not limited thereto, and the material of the insulation substrate 22 may alternatively be another insulation material, which is not strictly limited in this example. In addition, the conductive layer 23 and the metal substrate 21 may be made of metal materials, for example, materials such as copper, nickel, or aluminum, so that heat can be quickly dissipated for the chip 3. Materials of the conductive layer 23 and the metal substrate 21 may be the same or may be different.

The pin 4 may be electrically connected to the conductive layer 23. One end of the pin 4 may be fastened to the conductive layer 23, and the other end of the pin 4 may be exposed from the power module 10. For example, the pin 4 is welded to the second partition 232 of the conductive layer 23. When the bonding wire 6 is used to connect the chip 3 and the first partition 231, the pin 4 and the chip 3 may be electrically connected by using the bonding wire 6, so that the chip 3 may be electrically connected to another external component by using the pin 4. In some other embodiments, when the bottom of the chip 3 is electrically connected to the first partition 231 of the conductive layer 23, the pin 4 may be welded to the first partition 231, and the chip 3 may be electrically connected to another component by using the pin 4 of the first partition 231.

For example, the other end of the pin 4 may extend in a direction away from a surface of the substrate 2, to be exposed from a top surface of the power module 10. The pin 4 may be perpendicular to or approximately perpendicular to the substrate 2. Certainly, in another embodiment, the other end of the pin 4 may alternatively have another extension direction. This is not strictly limited in this embodiment of this application.

There may be a plurality of pins 4, and the plurality of pins 4 may be disposed around the chip 3, so that a structure of the power module 10 is more compact. It may be understood that the plurality of pins 4 are independent of each other. There are also a plurality of corresponding second partitions 232 welded to the pins 4, and the plurality of second partitions 232 are also independent of each other.

For example, the pin 4 may be roughly of a needle-shaped structure, or may be of a cylindrical structure, an elliptic cylindrical structure, a cuboid structure, a multilateral structure, or the like. A surface of the pin 4 may be plated with a metal film to improve electrical contact performance of the pin 4. A structure of the pin 4 is not strictly limited in this embodiment.

For example, a material of the pin 4 may be a metal such as copper, silver, or aluminum, or an alloy thereof. This is not strictly limited in this example. When there are a plurality of pins 4, shapes and materials of the plurality of pins 4 may be the same or may be different.

In some embodiments, at least a partial structure of the thermally conductive member 1 may be a conductive structure, and the shielding member 5 may be connected to the conductive structure of the thermally conductive member 1. In this case, the conductive structure of the thermally conductive member 1 can also have an electromagnetic shielding function. The conductive structure of the thermally conductive member 1 and the shielding member 5 may further form an equipotential body, to form a closed or approximately closed box-shaped structure. The equipotential body can wrap a complete or major structure of the substrate 2 and the chip 3, so that shielding effect of the power module 10 is better.

It may be understood that, when the shielding member 5 is connected to the conductive structure of the thermally conductive member 1, the shielding member 5 and the conductive structure of the thermally conductive member 1 may be in electrical contact. In this embodiment of this application, electrical contact is a state in which conductors are in contact with each other, allowing a current to pass through. The electrical contact does not require that the connected conductors be powered on.

In some examples, the conductive structure of the thermally conductive member 1 may be grounded, so that the thermally conductive member 1 and the shielding member 5 are grounded together, to form an equipotential body using ground as a reference point.

The thermally conductive member 1 may be approximately a plate-shaped member. The entire thermally conductive member 1 may be made of a metal material, for example, a copper plate, so that the thermally conductive member 1 can have relatively good thermal conductivity and relatively good conductive performance.

In some other embodiments, the thermally conductive member 1 may also form a conductive structure partially through metal plating or the like. This is not strictly limited in this embodiment.

In some embodiments, the power module 10 further includes a heat dissipation member 9, and the heat dissipation member 9 is fastened to a side that is of the thermally conductive member 1 and that faces away from the substrate 2. For example, the heat dissipation member 9 may be fastened, through welding, to the side that is of the thermally conductive member 1 and that faces away from the substrate 2. In this case, the thermally conductive member 1 may be made of a material with good heat dissipation effect, and the heat dissipation member 9 may be disposed of a structure with a relatively large surface area. The thermally conductive member 1 is configured to quickly dissipate heat of the substrate 2, and the heat dissipation member 9 quickly dissipates heat to an environment.

The heat dissipation member 9 may be an air-cooled heat sink or a liquid cooling heat sink. When the heat dissipation member 9 is an air-cooled heat sink, the heat dissipation member 9 may have a relatively large surface area, so that the heat dissipation member 9 can perform quick heat exchange with air, thereby quickly dissipating heat of the power module 10. When the heat dissipation member 9 is a liquid cooling heat sink, the heat dissipation member 9 can first transfer heat to a flowing liquid medium, and then perform cyclic heat dissipation after cooling the liquid medium, to implement quick heat dissipation for the power module 10.

For example, the heat dissipation member 9 may include a main body 91 and fins 92. The main body 91 is fastened to the thermally conductive member 1, and the fins 92 are fastened to a side that is of the main body 91 and that faces away from the thermally conductive member 1. The fin 92 may be of a thin plate structure, so that a single fin 92 has a relatively large surface area. There may be a plurality of fins 92, and the plurality of fins 92 may be spaced and arranged in parallel on the main body 91. An air duct may be formed between a fin 92 and another fin 92, which facilitates heat exchange with an external environment, so that the heat dissipation member 9 has a relatively good heat dissipation structure, and helps improve heat dissipation efficiency of the power module 10. The heat dissipation member 9 may be an integrated mechanical part. In this example, a structure of the heat dissipation member 9 is disposed, so that a surface area of the heat dissipation member 9 is larger and a heat dissipation capability is better, which improves heat dissipation efficiency of the power module 10.

For example, the heat dissipation member 9 may be made of a metal material, and the heat dissipation member 9 is connected to the shielding member 5. In this case, the heat dissipation member 9 may form a structure having a shielding capability as a whole, and the heat dissipation member 9 and the shielding member 5 may form a closed or approximately closed box-shaped structure, so that complete or major structures of the substrate 2 and the chip 3 can be wrapped, so that the shielding effect of the power module 10 is better.

For example, the heat dissipation member 9 may be in electrical contact with the shielding member 5 through the thermally conductive member 1. In this case, both the heat dissipation member 9 and the thermally conductive member 1 have a shielding capability. Alternatively, the heat dissipation member 9 may be in electrical contact with the shielding member 5 through another component, which is not strictly limited in this embodiment.

In some embodiments, the shielding member 5 may be disposed on the thermally conductive member 1. The shielding member 5 may be fastened to the thermally conductive member 1.

For example, the power module 10 may include bolts 7, and the shielding member 5 may be fastened to the thermally conductive member 1 by using the bolts 7. The shielding member 5 may be provided with through holes, and the thermally conductive member 1 may be provided with mounting holes corresponding to the through holes. The bolts 7 are threaded through the mounting holes, so that the bolts 7 are in a threaded connection to the mounting holes, and the shielding member 5 abuts against the thermally conductive member 1. This implements fixed installation of the shielding member 5. The mounting holes may penetrate the thermally conductive member 1 and be provided inside the main body 91. In this case, the bolts 7 can also improve reliability of a connection between the thermally conductive member 1 and the heat dissipation member 9.

In addition, the bolts 7 may be made of metal materials, and are electrically connected to the shielding member 5 and the thermally conductive member 1, which helps improve reliability of an electrical connection between the shielding member 5 and the thermally conductive member 1. In some examples, the bolts 7 may be welded to the shielding member 5, to ensure reliability of a connection between the bolts 7 and the shielding member 5.

In some embodiments, the power module 10 may further include a packaging member 8. The packaging member 8 may wrap the chip 3 and at least a partial structure of the substrate 2 and partial structures of the pins 4. In this case, the packaging member 8 can isolate the chip 3 and the substrate 2 from the outside, to avoid contact between the chip 3 and the substrate 2 and an external substance, and reduce impact of an external force. The packaging member 8 can fasten and support the pins 4. Therefore, the packaging member 8 can package the chip 3, the substrate 2, and the pins 4, and has a good protection capability. It may be understood that the pins 4 may be exposed relative to the packaging member 8.

For example, the packaging member 8 may be formed by using a plastic packaging process. The packaging member 8 may be made of a plastic packaging material, for example, epoxy resin. In this embodiment, the packaging member 8 formed by using the plastic packaging process has high structural strength and good sealing performance, and can improve strength and reliability of the packaging member 8.

For example, the packaging member 8 may be fastened to the thermally conductive member 1, a structure of the substrate 2 exposed from the thermally conductive member 1 may be wrapped by the packaging member 8, a structure of the chip 3 exposed from the substrate 2 may be wrapped by the packaging member 8, and the bonding wires 6 may also be wrapped by the packaging member 8.

For example, the packaging member 8 may have a top surface 81 and a side surface 82. The side surface 82 is disposed around the top surface 81, the top surface 81 may be a plane, and both the top surface 81 and the side surface 82 may be smooth surfaces, so that the packaging member 8 is easy to form.

For example, the packaging member 8 is located in the accommodating space of the shielding member 5, and a gap is reserved between the packaging member 8 and the shielding member 5, so that the shielding member 5 as a whole is disposed on an outer side of the packaging member 8. This facilitates installation of the shielding member 5. In some other embodiments, there may be no gap between the packaging member 8 and the shielding member 5. This is not strictly limited in this embodiment.

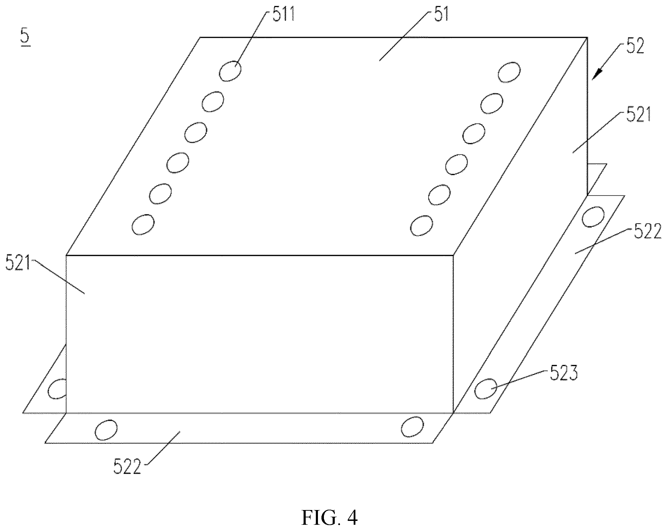

Refer to FIG. 3 and FIG. 4 together. FIG. 4 is a diagram of a structure of the shielding member 5 shown in FIG. 3 in some embodiments.

In some embodiments, the shielding member 5 may have a top portion 51 and a side portion 52. The side portion 52 may be disposed around the top portion 51, and the side portion 52 is fastened to the top portion 51. For example, in the power module 10, the side portion 52 of the shielding member 5 may surround the chip 3 and the substrate 2, and the top portion 51 of the shielding member 5 may be parallel to the substrate 2. In this case, the top portion 51 and the side portion 52 of the shielding member 5 jointly form a semi-open cover structure of the shielding member 5, so that the shielding member 5 has a relatively large accommodating volume and a relatively large shielding area.

For example, the shielding member 5 may be an integrally formed mechanical part. For example, the shielding member 5 may be formed through stamping or injection molding, which is not strictly limited in this embodiment. In this case, the integrally formed shielding member 5 has good integrity, is easy to form, and easily forms an equipotential body during operation, providing relatively good electromagnetic shielding effect.

For example, the top portion 51 of the shielding member 5 may be roughly of a rectangular plate structure. A shape of the top portion 51 may correspond to a shape of the substrate 2, so that a shape of the shielding member 5 is more regular and is simple to prepare.

The top portion 51 of the shielding member 5 may be provided with a plurality of avoidance holes 511, and the plurality of pins 4 penetrate the plurality of avoidance holes 511. The avoidance holes 511 are provided on the top portion 51 of the shielding member 5, so that the pins 4 can be disposed in a form perpendicular to or approximately perpendicular to the substrate 2, and the pins 4 can directly penetrate from the avoidance holes 511. This facilitates installation of the shielding member 5.

For example, the avoidance holes 511 and the pins 4 are disposed in a one-to-one correspondence, to be specific, a quantity of avoidance holes 511 is the same as a quantity of pins 4, and opening positions of the avoidance holes 511 are corresponding to the pins 4. This reduces removal of a material of the shielding member 5, and ensures shielding performance of the shielding member 5.

Alternatively, in some examples, the quantity of avoidance holes 511 may be less than the quantity of pins 4, so that a plurality of pins 4 may pass through one avoidance hole 511 together. This reduces a quantity of times of opening of the avoidance holes 511, making preparation of the shielding member 5 simpler.

The avoidance hole 511 may be a circular hole, a square hole, an elliptical hole, or the like, or may be a special-shaped hole, which is not strictly limited in this embodiment.

It may be understood that a gap is reserved between the avoidance hole 511 and the pin 4. A hole diameter of the avoidance hole 511 may be greater than a diameter of the pin 4. For example, a gap between the avoidance hole 511 and the pin 4 may be greater than 5 millimeters, but is not limited thereto. In this case, a gap is reserved between the avoidance hole 511 and the pin 4, to avoid contact between the pin 4 and the shielding member 5, prevent the pin 4 from failing, and facilitate smooth penetration of the pin 4 from the avoidance hole 511 during installation of the shielding member 5.

For example, the side portion 52 of the shielding member 5 may include a plurality of side plates 521 and fixed plates 522.

There may be four side plates 521. The four side plates 521 may all be fastened to the top portion 51, and adjacent side plates 521 may also be fastened together. The four side plates 521 may enclose a tubular structure, to wrap the chip 3 and the substrate 2.

The fixed plate 522 may be formed by a structure of an end that is of the side portion 52 and that is away from the top portion 51. The fixed plate 522 may be fastened to an end that is of the side plate 521 and that is away from the top portion 51. The fixed plate 522 is bent towards an outer side of the shielding member 5 relative to the side plate 521. The fixed plate 522 may be perpendicular to or approximately perpendicular to the connected side plate 521. There may be four fixed plates 522, that is, one side plate 521 is fastened to one fixed plate 522. In some other examples, there may also be two fixed plates 522, and the two side plates 521 are respectively connected to two opposite side plates 521.

In addition, the fixed plate 522 may be fastened to the thermally conductive member 1. For example, the fixed plate 522 may be provided with a plurality of through fixed holes 523. During fastening of the shielding member 5, the bolts 7 may pass through the fixed holes 523, to make the fixed plates 522 abut against a surface of the thermally conductive member 1.

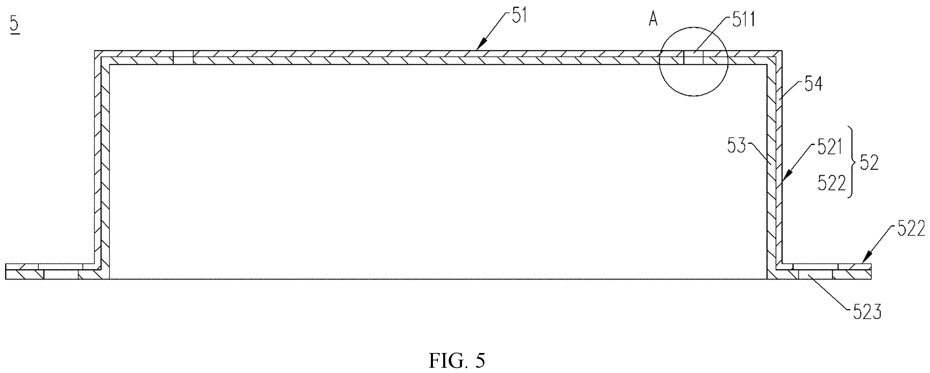

FIG. 5 is a sectional view of the shielding member 5 shown in FIG. 3 in some embodiments.

In some embodiments, the shielding member 5 may include a shield layer 53 and an insulation layer 54. The shield layer 53 is fastened to the insulation layer 54, and the shield layer 53 forms a shielding structure of the shielding member 5. In this embodiment, the shielding member 5 is disposed as a laminated structure, so that the shielding member 5 has relatively good insulation performance and shielding performance.

For example, the shield layer 53 may cover the accommodating space. A shape of the shield layer 53 may be basically the same as an overall shape of the shielding member 5. The shield layer 53 may be continuously distributed on the top portion 51 and the side portion 52, to form a shielding structure to a maximum extent, so as to better implement electromagnetic shielding for the chip 3 and the substrate 2 (refer to FIG. 3).

The shield layer 53 may be a cover-shaped plate structure. The shield layer 53 may be used as a main structure of the shielding member 5, and the shield layer 53 may support the insulation layer 54. It may be understood that, the plate-shaped structure means that a part of the shield layer 53 at the top portion 51 and a part of the shield layer 53 at the side portion 52 are roughly plate-shaped, and does not mean that the shield layer 53 is plate-shaped as a whole.

The shield layer 53 may be made of a conductive material, and therefore has a conductive property and implements electromagnetic shielding. For example, the shield layer 53 may be made of a composite material formed by tungsten and aluminum oxide, and the shield layer 53 formed in this way has relatively high strength and relatively good conductivity, so that the shielding member 5 has higher structural strength and better shielding performance. Alternatively, the shield layer may be made of a metal such as copper or aluminum, or an alloy material including the metal.

For example, the insulation layer 54 may be at least partially connected to an outer side of the shield layer 53. The insulation layer 54 may cover most parts of the outer side of the shield layer 53, to insulate the outer side of the shield layer 53, and prevent another external component from being in electrical contact with the shield layer 53.

For example, the insulation layer 54 may be continuously distributed on an outer surface of the top portion 51, and continuously distributed on an outer surface of the side plate 521. For the fixed plate 522 of the side portion 52, the insulation layer 54 may be distributed on a part of the outer surface of the fixed plate 522, to avoid another component (for example, the bolt 7 in FIG. 3) when the another component (for example, the bolt 7 in FIG. 3) is electrically connected to the shield layer 53. In some other embodiments, the insulation layer 54 may not be distributed at the fixed plate 522 of the side portion 52. This is not strictly limited in this embodiment.

The insulation layer 54 may be made of an insulation material, for example, may be made of insulation paint or plastic, which is not strictly limited in this embodiment.

In some other embodiments, the insulation layer 54 may further cover an inner side of the shield layer 53. This is not strictly limited in this embodiment.

In some other embodiments, the shielding member 5 may not have the insulation layer 54. In other words, the shielding member 5 is made of a metal material as a whole, and the shielding member 5 forms a shielding structure as a whole.

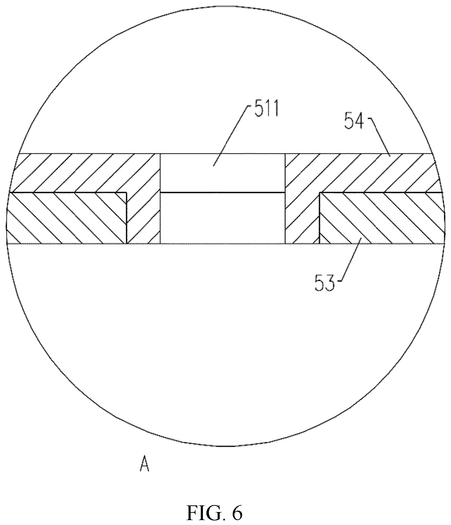

FIG. 6 is an enlarged view of an A part of the shielding member 5 shown in FIG. 5 in some other embodiments.

In some embodiments, the insulation layer 54 may cover a hole wall of the avoidance hole 511. For example, on the top portion 51 of the shielding member 5, the insulation layer 54 extends from the outer side of the shield layer 53 to a hole wall of the avoidance hole 511, and covers the hole wall of the avoidance hole 511. In this case, the shield layer 53 forms an insulation structure at the avoidance hole 511, to prevent the pin 4 (refer to FIG. 3) from being in electrical contact with the shield layer 53 due to an installation error or an external force, and therefore prevent the pin 4 from failing and improve reliability of the power module 10 (refer to FIG. 3).

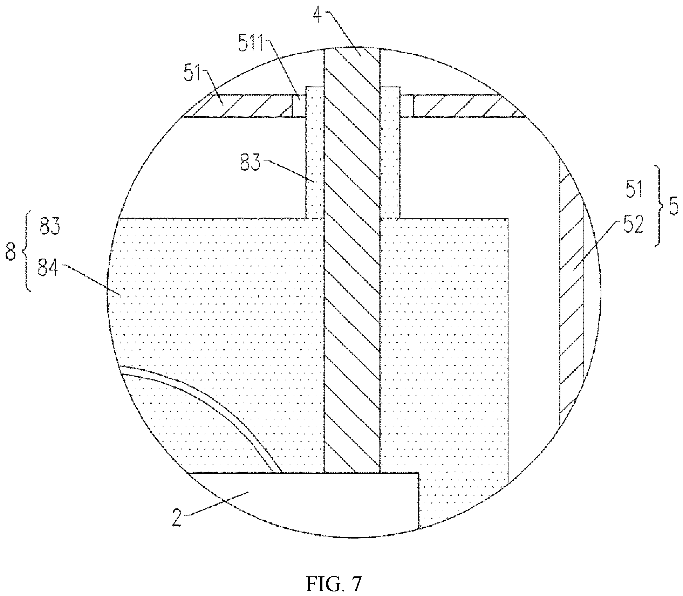

FIG. 7 is a partial view of the power module 10 shown in FIG. 3 in some other embodiments.

In some embodiments, the packaging member 8 may include a protrusion 83 and a package body 84. The protrusion 83 is disposed on a side that is of the package body 84 and that faces away from the thermally conductive member 1 (refer to FIG. 3). For example, the protrusion 83 may be fastened on the side that is of the package body 84 and that faces away from the thermally conductive member 1, and the protrusion 83 and the package body 84 may be integrally formed by using a plastic packaging process.

For example, the protrusion 83 may surround the pin 4. The protrusion 83 wraps a periphery of a partial structure of the pin 4, to support and protect the pin 4. In some examples, a partial structure of the protrusion 83 may be embedded in the avoidance hole 511. In this case, because the pin 4 is relatively long, the protruding protrusion 83 can cover more parts of the pin 4; and when the pin 4 is subject to an external force, the pin 4 may be prevented from direct contact with the hole wall of the avoidance hole 511. This improves reliability of the pin 4 and improves reliability of the power module 10.

In some examples, the protrusion 83 may be exposed relative to the top portion 51 of the shielding member 5. In some examples, a gap may be reserved between the protrusion 83 and the hole wall of the avoidance hole 511. In some other examples, the protrusion 83 may alternatively be flush with the top portion 51 of the shielding member 5.

For example, the package body 84 may wrap the chip 3 (refer to FIG. 3) and the substrate 2. The package body 84 may be a part of the packaging member 8 other than the protrusion 83, and the protrusion 83 and the package body 84 may not have a clear dividing line. This is not strictly limited in this embodiment.

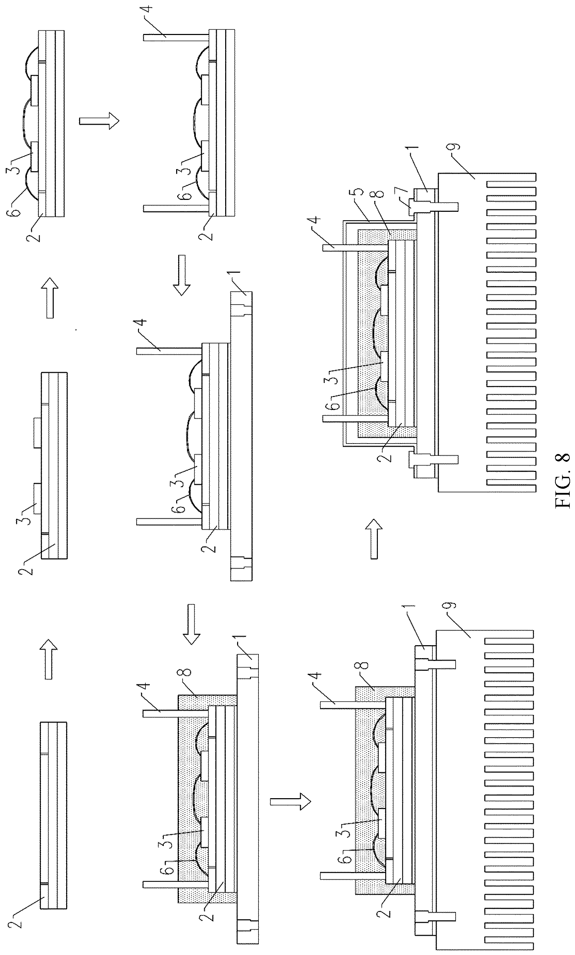

FIG. 8 is a brief flowchart of a preparation method of the power module 10 shown in FIG. 3 in some embodiments. In some embodiments, the preparation method of the power module 10 includes the following steps:
Step S102: Weld a chip 3 to a substrate 2. The chip 3 may be first mounted on the substrate 2, solder may be coated between the chip 3 and the substrate 2, and then the chip 3 is welded through reflow soldering, so that the chip 3 is fastened to the substrate 2.

Step S104: Electrically connect the top of the chip 3 to the substrate 2 by using a bonding wire 6. One end of the bonding wire 6 may be connected to the top of the chip 3 by using a process such as ultrasonic bonding or hot pressing bonding, and the other end may be connected to a corresponding position of the substrate 2, to implement an electrical connection between the top of the chip 3 and the substrate 2.

Step S106: Weld a pin 4 to the substrate 2. Solder may be coated between the pin 4 and the substrate 2, and the pin 4 may be fastened to a to-be-welded position of the substrate 2 at a vertical or approximately vertical angle by using a jig. The to-be-welded position may be a position connected to the bonding wire 6. Then, the pin 4 is welded to the substrate 2 through reflow soldering, so that the substrate 2 is electrically connected to the chip 3 by using the bonding wire 6.

Step S108: Fasten a thermally conductive member 1 to the substrate 2. Solder may be coated between the thermally conductive member 1 and a side that is of the substrate 2 and that faces away from the chip 3, and then the thermally conductive member 1 is fastened to the substrate 2 through reflow soldering.

Step S110: Form a packaging member 8. A mold may be disposed on an outer side of the chip 3 and the substrate 2, and then a plastic package material is added to the mold to form the packaging member 8 on the outer side of the chip 3 and the substrate 2.

Step S112: Fasten a heat dissipation member 9 to the thermally conductive member 1. Solder may be coated between the heat dissipation member 9 and a side that is of the thermally conductive member 1 and that is away from the substrate 2, and the heat dissipation member 9 is fastened to the thermally conductive member 1 through reflow soldering.

Step S114: Fasten a shielding member 5 to the thermally conductive member 1. The bolts 7 pass through the shielding member 5, and are in a threaded connection to the heat dissipation member 9 to fasten the shielding member 5.

In this embodiment, for structures and connection manners of the substrate 2, the chip 3, the bonding wire 6, the pin 4, the thermally conductive member 1, the heat dissipation member 9, the packaging member 8, and the shielding member 5, refer to the related solution in the embodiment in FIG. 3, and details are not described in this embodiment again.

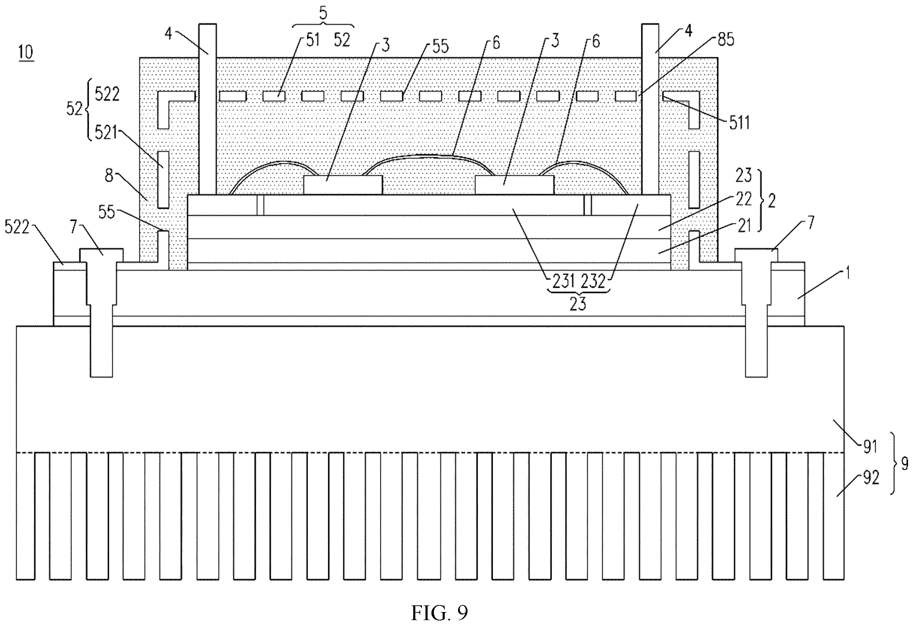

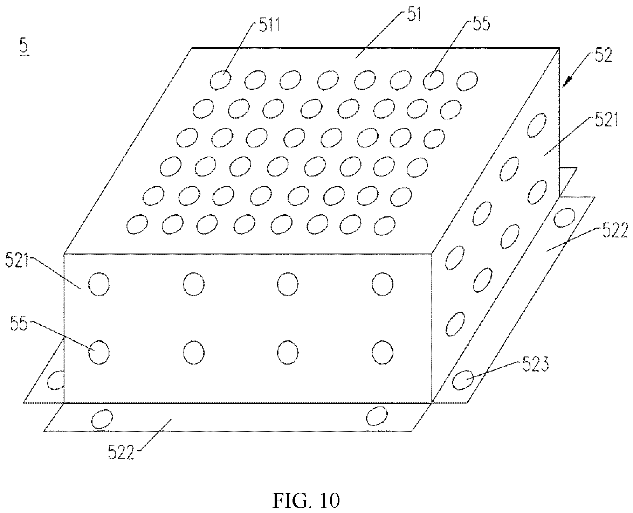

Refer to FIG. 9 and FIG. 10 together. FIG. 9 is a diagram of an internal structure of the power module 10 shown in FIG. 2 in some other embodiments. FIG. 10 is a diagram of a structure of the shielding member 5 shown in FIG. 9 in some embodiments. The power module 10 shown in the embodiment in FIG. 9 may include major technical features of the power module 10 shown in the embodiment in FIG. 3. A same technical feature of the power module 10 in the embodiments in FIG. 3 and FIG. 9 is not described in this embodiment. The following mainly describes a difference between the two. A difference between the power module 10 shown in the embodiment in FIG. 9 and the power module 10 shown in the embodiment in FIG. 3 lies in relative positions of the shielding member 5 and the packaging member 8.

In some embodiments, the packaging member 8 wraps at least a structure of the shielding member 5 that forms accommodating space.

For example, the packaging member 8 may wrap a top portion 51 of the shielding member 5, the packaging member 8 may further wrap a side plate 521 of a side portion 52 of the shielding member 5, and a fixed plate 522 of the side portion 52 may be exposed from the packaging member 8, which is equivalent to wrapping a major structure of the shielding member 5 inside the packaging member 8. In this case, the wrapped parts (that is, the top portion 51 and the side plate 521) of the shielding member 5 do not have electrical contact with another external component, and do not have electrical contact with a pin 4. In addition, with the package by the packaging member 8, the shielding member 5 is not directly impacted by an external force, the packaging member 8 can protect the shielding member 5, and integrity of the power module 10 is good. In addition, the fixed plates 522 of the side portion 52 are exposed from the packaging member 8, and the fixed plates 522 may be fastened to a thermally conductive member 1 by using bolts 7, so that a connection between the shielding member 5 and the thermally conductive member 1 is more reliable, and a service life of the power module 10 is long.

For example, the shielding member 5 may be provided with a flow-guiding hole 55. The flow-guiding hole 55 may penetrate the shielding member 5. In this case, a part that is of the packaging member 8 and that is located on an outer side of the shielding member 5 is connected to a part that is of the packaging member 8 and that is located on an inner side of the shielding member 5 through the flow-guiding hole 55. The flow-guiding hole 55 is provided, so that during forming of the packaging member 8, plastic packaging materials can be evenly distributed on an inner side and an outer side of the packaging member 8, to form an integrated packaging member 8. The packaging member 8 has good integrity and a better protection ability.

The flow-guiding hole 55 may be a circular hole, a square hole, an elliptical hole, or the like, or may be a special-shaped hole. In some examples, a shape and a size of the flow-guiding hole 55 may be the same as a shape and a size of the avoidance hole 511, to facilitate machining. The shape of the flow-guiding hole 55 is not strictly limited in this embodiment.

There may be a plurality of flow-guiding holes 55. The flow-guiding holes 55 may be disposed on the top portion 51 and the side portion 52 of the shielding member 5. Opening density of flow-guiding holes 55 in the top portion 51 of the shielding member 5 may be relatively high. For example, more than 80% of materials may be removed, so that the top portion 51 forms a honeycomb structure, and still has a relatively good shielding capability. For example, opening density of flow-guiding holes 55 in the side portion 52 of the shielding member 5 may be relatively low. For example, more than 20% of materials may be removed, so that the side portion 52 forms a porous structure, and also has a relatively good shielding capability.

In some embodiments, the packaging member 8 may include a connecting portion 85.

For example, the connecting portion 85 may surround the pin 4. The connecting portion 85 wraps a periphery of a partial structure of the pin 4, to support and protect the pin 4.

For example, another part of the packaging member 8 other than the connecting portion 85 may wrap a chip 3 and a substrate 2.

For example, the connecting portion 85 of the packaging member 8 may be located inside the packaging member 8. In this case, because the packaging member 8 wraps the top portion 51 of the shielding member 5, the packaging member 8 is higher than the top portion 51 of the shielding member 5. The connecting portion 85 is located in the avoidance hole 511 of the shielding member 5, and may be in contact with the avoidance hole 511, so that the pin 4 is almost in no electrical contact with the shielding member 5, and reliability and stability of the pin 4 are high.

In this embodiment, for structures and connection relationships of the chip 3, the substrate 2, the pin 4, and the thermally conductive member 1 of the power module 10, refer to the related solution of the power module 10 in the embodiment in FIG. 3, and details are not described in this embodiment again.

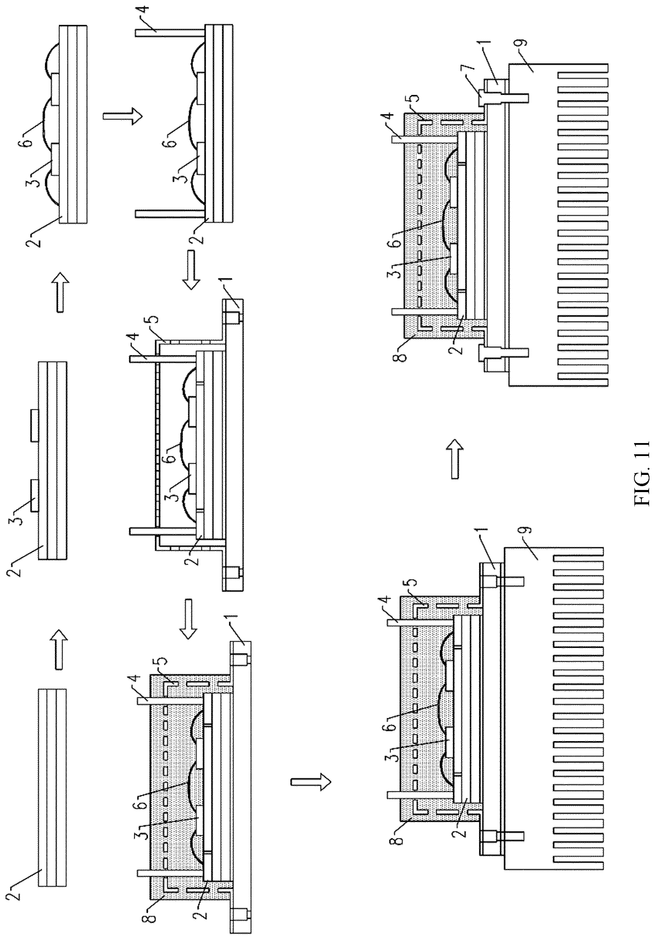

FIG. 11 is a brief flowchart of a preparation method of the power module 10 shown in FIG. 9 in some embodiments. The preparation method shown in the embodiment in FIG. 11 may include major technical features of the preparation method shown in the embodiment in FIG. 8. The following mainly describes a difference between the two. A difference between the preparation method shown in the embodiment in FIG. 11 and the preparation method shown in the embodiment in FIG. 8 mainly lies in installation of a shielding member 5.

In some implementations, the preparation method of the power module 10 includes the following steps:
For step S202 to step S206, refer to step S102 to step S106 respectively. Details are not described in this embodiment again.

Step S208: Fasten a thermally conductive member 1 to a substrate 2, and install a shielding member 5 on the thermally conductive member 1. Solder may be coated between the thermally conductive member 1 and a side that is of the substrate 2 and that faces away from a chip 3, and then the thermally conductive member 1 is fastened to the substrate 2 through reflow soldering. The shielding member 5 may be detachably connected to the thermally conductive member 1, or the shielding member 5 may be welded to the thermally conductive member 1, which is not strictly limited in this embodiment.

Step S210: Form a packaging member 8. A mold may be disposed on an outer side of the shielding member 5, and then a plastic package material is added to the mold to form the packaging member 8.

Step S212: Fasten a heat dissipation member 9 to the thermally conductive member 1. For details, refer to step S112 in the embodiment in FIG. 8.

Step S214: Install a bolt 7. The bolt 7 may be installed between the shielding member 5, the thermally conductive member 1, and the heat dissipation member 9, so that connection between the shielding member 5, the thermally conductive member 1, and the heat dissipation member 9 is more reliable.

It should be noted that embodiments in this application and features in embodiments may be combined with each other without a conflict, and any combination of features in different embodiments also falls within the protection scope of this application. In other words, the foregoing described plurality of embodiments may further be combined according to an actual requirement.

It should be noted that all the accompanying drawings are example illustration of this application, and do not represent an actual size of a product. In addition, proportion relationships of sizes between the components in the accompanying drawings are not intended to limit an actual product in this application.

The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising:
a thermally conductive member;
a substrate, disposed on the thermally conductive member;
a chip, disposed on a side that is of the substrate and that faces away from the thermally conductive member;
a plurality of pins, wherein one end of each of the plurality of pins is fastened on the side that is of the substrate and that faces away from the thermally conductive member, and the plurality of pins are electrically connected to the chip; and
a shielding member, wherein the shielding member is disposed on a side that is of the thermally conductive member and that is close to the chip, accommodating space is formed between the shielding member and the thermally conductive member, the chip and the substrate are located in the accommodating space, and the other end of each of the plurality of pins is exposed relative to the shielding member.

2. The power module according to claim 1, wherein the shielding member has a top portion and a side portion, the side portion is disposed around the top portion, the side portion surrounds the chip and the substrate, and the shielding member is an integrally formed mechanical part.

3. The power module according to claim 2, wherein the top portion is provided with a plurality of avoidance holes, and the plurality of pins penetrate the plurality of avoidance holes; and
the avoidance holes and the pins are provided in a one-to-one correspondence, or one avoidance hole is penetrated by a plurality of pins.

4. The power module according to claim 1, wherein the shielding member comprises a shield layer and an insulation layer, the shield layer covers the accommodating space, the insulation layer is at least partially located on an outer side of the shield layer, the shield layer is made of a conductive material, and the insulation layer is made of an insulation material.

5. The power module according to claim 4, wherein the shield layer is of a cover-shaped plate structure, and the shield layer is made of a composite material of tungsten and aluminum oxide.

6. The power module according to claim 4, wherein the shielding member is provided with a plurality of avoidance holes, the plurality of pins penetrate the plurality of avoidance holes, and the insulation layer covers hole walls of the avoidance holes.

7. The power module according to any one of claims 1 to 6, wherein at least a partial structure of the thermally conductive member is a conductive structure, and the shielding member is connected to the conductive structure of the thermally conductive member.

8. The power module according to any one of claims 1 to 6, wherein the power module further comprises a heat dissipation member, and the heat dissipation member is disposed on a side that is of the thermally conductive member and that faces away from the substrate; and
the heat dissipation member is an air-cooled heat sink or a liquid cooling heat sink.

9. The power module according to claim 8, wherein the heat dissipation member is made of a metal material, and the heat dissipation member is connected to the shielding member.

10. The power module according to any one of claims 1 to 6, wherein the power module further comprises a packaging member, and the packaging member wraps the chip and at least a partial structure of the substrate and partial structures of the pins.

11. The power module according to claim 10, wherein the packaging member is located in the accommodating space, and a gap is reserved between the packaging member and the shielding member.

12. The power module according to claim 11, wherein the packaging member comprises a package body and protrusions, the package body wraps the chip and the substrate, and wraps the partial structures of the pins, the protrusion is disposed on a side that is of the package body and that faces away from the thermally conductive member, the protrusion is disposed around the pin, and a partial structure of the protrusion is embedded in the avoidance hole of the shielding member.

13. The power module according to claim 10, wherein the packaging member wraps at least a structure of the shielding member that forms the accommodating space.

14. The power module according to claim 13, wherein the shielding member is provided with a flow-guiding hole, and a part that is of the packaging member and that is located on an outer side of the shielding member is connected to a part that is of the packaging member and that is located on an inner side of the shielding member through the flow-guiding hole.

15. A power converter, comprising a drive board and the power module according to any one of claims 1 to 14, wherein the power module is connected to the drive board.
